# EUROPEAN PATENT APPLICATION

(11) **EP 4 238 920 A1**
(43) Date of publication of application: **06.09.2023**
(21) Application number: 22216425.3
(22) Date of filing: 23.12.2022
(51) Int. Cl.: B66B 5/00, G01R 31/34

(54) **FAULT MONITORING DEVICE AND METHOD FOR ELEVATOR MOTOR**

(30) Priority: 03.03.2022 CN 202210208212
(71) Applicant: Otis Elevator Company, Farmington, Connecticut 06032 (US)
(72) Inventor: ZHOU, Hua, Tianjin, 300457 (CN); LI, Gousong, Tianjin, 300457 (CN)
(74) Representative: Dehns

(57) **Abstract**

The present application relates to elevator technology, in particular to a fault monitoring device and method for elevator motor and computer-readable storage medium on which computer programs (540) for implementing the method are stored. According to an aspect of the present application, there is provided a fault monitoring device for an elevator motor, comprising: a memory (520); a processor (530) coupled with the memory (520); and a computer program (540) stored on the memory and running on the processor (530), the running of the computer program (540) causes: A. determining one or more components of a stator coil current at one or more characteristic frequencies from a measurement of the stator coil current of the elevator motor; and B. determining, based on the one or more components, whether a fault of turn-to-turn short circuit occurs in the stator coil.

## Description

### Technical field

The present application relates to elevator technology, in particular to a fault monitoring device and method for elevator motor and computer-readable storage medium on which computer programs for implementing the method are stored.

### Background

As operating time increases, the probability of failure of the elevator motor will increase. For some faults (e.g., turn-to-turn short circuit of stator coil), the elevator motor will still be able to operate at its early stages, but will eventually cause the motor to stop. As the occurrence of stall is often sudden and unpredictable, there are potential safety hazards. For example, if the stall happens when passengers are taking the elevator, the passengers will be trapped in a car.

### Summary

According to an aspect of the present application, there is provided a fault monitoring device for an elevator motor, comprising:
a memory;
a processor coupled with the memory; and
a computer program stored on the memory and running on the processor, the running of the computer program causes (e.g. the fault monitoring device) to:
   A. determine one or more components of a stator coil current at one or more characteristic frequencies from a measurement of the stator coil current of the elevator motor; and
   B. determine, based on the one or more component, whether a fault of turn-to-turn short circuit occurs in the stator coil.

Optionally, the fault monitoring device is a computing device comprising the memory and the processor coupled with the memory. Optionally, the fault monitoring device is a computing device independent of an elevator controller and a power control device used to control the elevator motor.

Optionally, in the above fault monitoring device, the running of the computer program further causes to:
C. send a message to the elevator controller that the turn-to-turn short circuit has occurred in the stator coil.

Optionally, in the above fault monitoring device, the elevator controller generates a control command to stop an elevator car to a specified floor station based on the message that the turn-to-turn short circuit has occurred in the stator coil.

In addition to one or more features described above, in the above fault monitoring device, the stator coil current is a q-axis current of the elevator motor.

In addition to one or more features described above, in the above fault monitoring device, the characteristic frequencies take values of 2nxMEF, wherein n is a natural number and MEF is a Motor Electrical Frequency of the elevator motor.

Optionally, in the above fault monitoring device, the running of the computer program causes operation A to be performed by:
A1. receiving the measurement of the stator coil current from a current sampling module;
A2. performing a fast Fourier analysis on the measurement of the stator coil current to generate a current frequency spectrum;
A3. obtaining the components of the stator coil current at the one or more characteristic frequencies from the current frequency spectrum.

Optionally, in the above fault monitoring device, the running of the computer program causes operation B to be performed in the following manner:
if it is determined that the component of the stator coil current at the one or more characteristic frequencies is greater than respective thresholds, the fault of turn-to-turn short circuit in the stator coil is determined to have occurred.

Optionally, in the above fault monitoring device, the running of the computer program further causes operation B to be performed in the following manner:
determining a level of the fault of turn-to-turn short circuit in the stator coil based on a degree of upward deviation of the components of the stator coil current at the one or more characteristic frequencies relative to the respective thresholds.

In addition to one or more features described above, in the above fault monitoring device, the respective thresholds are set based on the number of turns of the stator coil of the elevator motor, and the respective thresholds decrease as the number of turns increases.

According to another aspect of the present application, there is provided a power control device for controlling an elevator motor, comprising:
a current sampling module;
a power conversion module;
a control module coupled with the current sampling module and the power conversion module, configured to perform the following operations:
   A. determining one or more components of a stator coil current at one or more characteristic frequencies from the stator coil current of the elevator motor measured by the current sampling module; and
   B. determining, based on the one or more components, whether a fault of turn-to-turn short circuit occurs in the stator coil.

Optionally, the power control device is a frequency converter.

Optionally, in the above power control device, the control module is further configured to:
C. send a message to an elevator controller that the turn-to-turn short circuit has occurred in the stator coil; and
D. provide a required voltage and frequency regulated power supply to the elevator motor by controlling the power conversion module based on a control command received from the elevator controller, wherein the control command is generated based on the message that the turn-to-turn short circuit has occurred in the stator coil.

According to another aspect of the present application, there is provided a fault monitoring method for an elevator motor, comprising:
A. determining one or more components of a stator coil current at one or more characteristic frequencies from a measurement of the stator coil current of the elevator motor; and
B. determining, based on the one or more components, whether a fault of turn-to-turn short circuit occurs in the stator coil.

According to another aspect of the present application, there is provided a computer-readable storage medium on which a computer program suitable for execution on a processor of a terminal device is stored, and the execution of the computer program causes steps of the method described above to be executed.

### Description of the drawings

The above and/or other aspects and advantages of the present application will be clearer and more easily understood from the following description of various aspects in conjunction with the accompanying drawings, in which the same or similar elements are specified by the same reference numerals. The accompanying drawings include:
FIG. 1 shows torque vs. position curves when there is no turn-to-turn short circuit and when the turn-to-turn short circuit occurs in a stator coil.
FIGs. 2A and 2B show frequency spectra of stator coil currents when there is no turn-to-turn short circuit and when a single turn of the turn-to-turn short circuit occurs in a stator coil.
FIG. 3 is a flow chart of a fault monitoring method for an elevator motor in accordance with some embodiments of the present application.
FIG. 4 is a flow chart of a method for determining characteristic frequency components of a stator coil current in accordance with some other embodiments of the present application.
FIG. 5 is a schematic block diagram of a typical computing device.
FIG. 6 is a schematic block diagram of a power control device for controlling an elevator motor in accordance with some other embodiments of the present application.
FIG. 7 is a schematic diagram of a motor fault monitoring process in accordance with some other embodiments of the present application.
FIG. 8 is a schematic block diagram of a control module included in the power control device of FIG. 6.

### Detailed description

The present application is described more fully below with reference to the accompanying drawings, in which illustrative embodiments of the application are illustrated. However, the present application may be implemented in different forms and should not be construed as limited to the embodiments presented herein. The presented embodiments are intended to make the disclosure herein comprehensive and complete, so as to more comprehensively convey the protection scope of the application to those skilled in the art.

In this specification, terms such as "comprising" and "including" mean that in addition to units and steps that are directly and clearly stated in the specification and claims, the technical solution of the application does not exclude the presence of other units and steps that are not directly and clearly stated in the specification and claims.

Unless otherwise specified, terms such as "first" and "second" do not indicate the order of the units in terms of time, space, size, etc., but are merely used to distinguish the units.

The inventors of the application have found, after research, that when a turn-to-turn short circuit occurs in a stator coil, a corresponding counter-electromotive force will be generated, resulting in a short-circuit current. This short-circuit current may induce a pulsating magnetic field, which contains a clockwise rotating component and a counterclockwise rotating component. The clockwise rotating component will be superimposed on a component of main magnetic field, while the counterclockwise rotating component will generate a torque ripple of 2 times the electrical frequency (MEF).

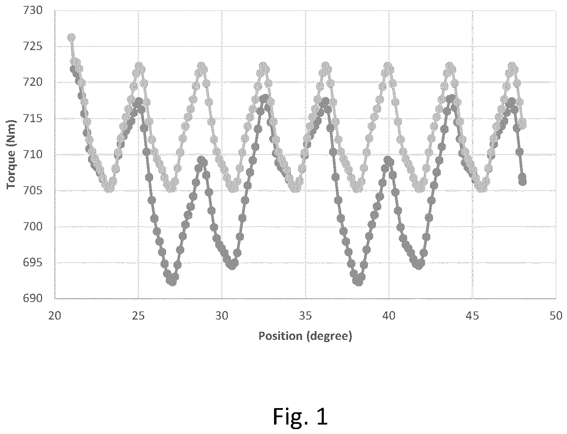

FIG. 1 shows torque vs. position curves when there is no turn-to-turn short circuit and when the turn-to-turn short circuit occurs in a stator coil, where the upper curve corresponds to the case of no turn-to-turn short circuit and the lower curve corresponds to the case of a single turn of the turn-to-turn short circuit (i.e., only one turn-to-turn short circuit occurs). In an example shown in FIG. 1, a motor has the following structural parameters: the number of stator slots is 36, and each stator slot has 36 turns of winding, so each phase of the three phases has 432 turns of winding.

As shown in FIG. 1, the relationship between torque and position shows a clear difference when there is no turn-to-turn short circuit and when the turn-to-turn short circuit occurs. This difference will result in different spectral characteristics of the current flowing through the stator coil.

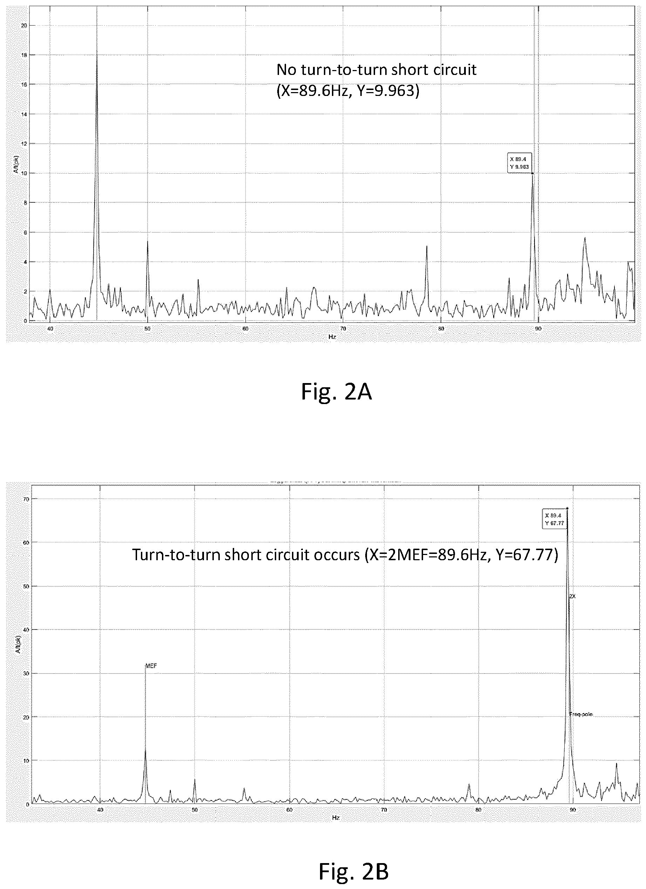

Taking the motor with the above structural parameters as an example, FIGs. 2A and 2B show frequency spectra of stator coil currents when there is no turn-to-turn short circuit and when a single turn of the turn-to-turn short circuit occurs in a stator coil, with a horizontal axis indicating the frequency in Hz and a vertical axis indicating the stator coil current iq along q-axis (for schematic purposes, the current values here do not represent actual measurements). The spectra shown in FIGs. 2A and 2B can be obtained, for example, by performing a fast Fourier analysis on the measured stator coil currents. By comparing FIGs. 2A and 2B, it can be seen that when the turn-to-turn short circuit occurs at a frequency twice the electrical frequency (MEF) (89.6Hz in the figures), the component of q-axis current iq increases significantly (from 9.963 to 67.77). The increase will be greater when more turns of the turn-to-turn short circuit occur.

It should be noted that the differences in the spectral characteristics of the stator coil currents described above when there is no turn-to-turn short circuit and when the turn-to-turn short circuit occurs are also applicable for other currents (e.g., a current id along d-axis).

It should also be noted that, although not shown in FIGs. 2A and 2B, for no turn-to-turn short circuit and the occurrence of the turn-to-turn short circuit, the components of the stator coil currents at other characteristic frequencies (e.g., 2n times the electrical frequency, where n = 2,3 ......), in addition to the frequency component 2 times the MEF, have similar differences.

In some embodiments of the present application, it is determined whether the stator coil has the turn-to-turn short circuit based on the components of the stator coil current at one or more characteristic frequencies. Optionally, the aforementioned components may be compared to their respective corresponding thresholds, and if the one ore more components are greater than their respective thresholds, it is determined that a fault of the turn-to-turn short circuit in the stator coil has occurred.

The thresholds for determining the fault may be set based on various factors, which include, for example, but are not limited to, structural parameters of the motor and sensitivity requirements for fault monitoring, among others. In an example, the thresholds may be set based on the number of turns of the stator coil. When the number of turns of the coil is larger, the thresholds can be set smaller, and when the number of turns of the coil is smaller, the thresholds can be set larger.

Since the fault of the turn-to-turn short circuit usually undergoes a development process from early to late stages, the fault of the turn-to-turn short circuit can be identified at an early stage by using the characteristic frequency components of the stator coil current, which can reserve enough processing time for fault handling, thereby eliminating safety hazards.

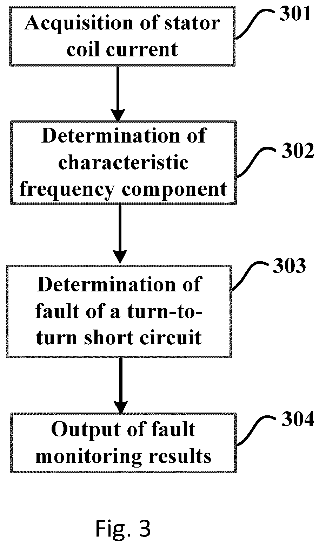

FIG. 3 is a flow chart of a fault monitoring method for an elevator motor in accordance with some embodiments of the present application. The fault monitoring method shown in FIG. 3 can be performed in a real-time manner or in a non-real-time manner depending on the application requirements. In addition, the method described below may be implemented by various devices that include, for example, but are not limited to, a power control device (e.g., a frequency converter), an elevator controller and a computing device independent of the elevator controller and the power control device, among others. When the real-time processing capabilities of the power control device and elevator controller are insufficient or computing resources are strained, it is advantageous to implement fault monitoring using the independent computing device. In addition, the independent device can act as nodes of the Internet of Things system or network edge computing nodes to perform fault monitoring in real or non-real time and report fault monitoring results to higher-level devices (e.g., elevator controller and cloud server), so as to achieve fault monitoring and fault handling of elevator motors in a wide range.

The fault monitoring method for the elevator motor shown in FIG. 3 comprises the following steps:

### Step 301: acquisition of the stator coil current of the elevator motor

In this step, the fault monitoring device acquires a measurement of the stator coil current. In an example, when the fault monitoring device does not have current measurement capability, it may receive the measurement of the stator coil current from an external current sampling module. As another example, when the fault monitoring device itself has current measurement capability (e.g., the fault monitoring device is implemented as a frequency converter), it may measure the stator coil current using its own current sampling module.

### Step 302: determination of the characteristic frequency components

In this step, the fault monitoring device determines the components of the stator coil current at one or more characteristic frequencies from the measurement of the stator coil current of the elevator motor. As mentioned above, the characteristic frequencies may be 2n times the electrical frequency of the motor (n is a natural number). Optionally, the q-axis current of the elevator motor may be selected as the type of stator coil current used to determine a fault of the turn-to-turn short circuit.

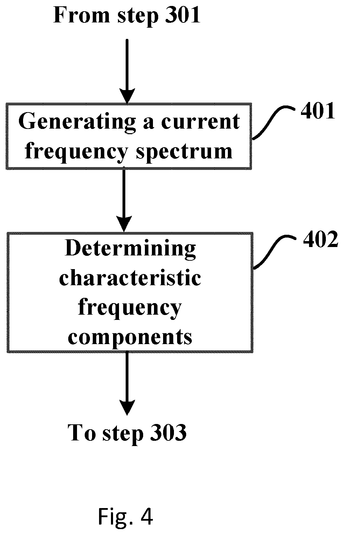

Exemplarily, the components of the stator coil current at the characteristic frequencies can be determined using the method shown in FIG. 4. Specifically, the method shown in FIG. 4 includes the following steps:
Step 401: performing a fast Fourier analysis on the measurement of the stator coil current obtained at step 301, thereby generating frequency spectra of currents in the form shown in FIGs. 2A and 2B, for example.
Step 402: determining the components of the stator coil current at the characteristic frequency from the generated frequency spectra. In the example of FIGs. 2A and 2B, the component at a specific frequency is the value of q-axis current iq at a frequency of 89.6 Hz.

### Step 303: determination of the fault of the turn-to-turn short circuit

In this step, the fault monitoring device determines whether the elevator motor has the fault of the turn-to-turn short circuit in the stator coil based on the characteristic frequency components determined in step 402.

Taking a single frequency component y_{f} of the stator coil current (e.g., a component of current i_{q} at 2 times the frequency of MEF) as an example, the fault of the turn-to-turn short circuit can be determined in the following manner. First, the frequency component Y_{f} is compared with the set threshold TH, and then a fault determination result is obtained based on the comparison result. Specifically, if the frequency component Y_{f} is greater than the threshold TH, it is determined that the fault of the turn-to-turn short circuit has occurred, otherwise, it is determined that no fault of the turn-to-turn short circuit has occurred. Further, in this step, the severity of the turn-to-turn short circuit or the level of the fault can also be estimated based on a degree of upward deviation of the frequency component Y_{f} relative to the threshold TH.

In addition, taking a plurality of frequency components {Yᵢ} of the stator coil current (e.g., a plurality of components of the current i_{q} at 2n times the frequency of MEF, n=1, 2 ... i ...) as an example, the fault of the turn-to-turn short circuit can be determined in the following manner. First, each frequency component Yᵢ is compared with its corresponding threshold THᵢ, and then the fault is determined based on the comparison result. Exemplarily, if at least m of the plurality of frequency components are greater than their respective thresholds, it is determined that the fault of the turn-to-turn short circuit has occurred, otherwise, it is determined that no fault of the turn-to-turn short circuit has occurred. Similarly, in this step, the severity of the turn-to-turn short circuit or the level of the fault can also be estimated based on the mean (arithmetic mean or weighted mean) of the degree of upward deviation of each frequency component Yᵢ relative to their respective thresholds THᵢ. The components of the stator coil current at multiple frequencies present details of the individual characteristics of the motor, so it is possible to obtain more refined fault information by using this "spectral fingerprint".

### Step 304: output of fault monitoring results

In this step, the fault monitoring device sends monitoring results to an external device (e.g., an elevator controller). For example, when it is determined that the fault of the turn-to-turn short circuit has occurred at step 303, the fault monitoring device will send a message to the external device that the turn-to-turn short circuit has occurred in the stator coil, so that the external device can generate a corresponding control command or perform a corresponding operation (for example, generate a control command to stop an elevator car to a specified floor station) based on the message that the turn-to-turn short circuit has occurred in the stator coil. The specified floor station mentioned here may be, for example, the floor station closest to the current location of the car.

The sending of messages between the fault monitoring device and the external device can be realized in the form of wireless communication and wired communication. Optionally, the wireless communication may be based on various communication protocols, including, for example, but not limited to, Wi-Fi communication protocol, Bluetooth communication protocol and Zigbee communication protocol, etc.

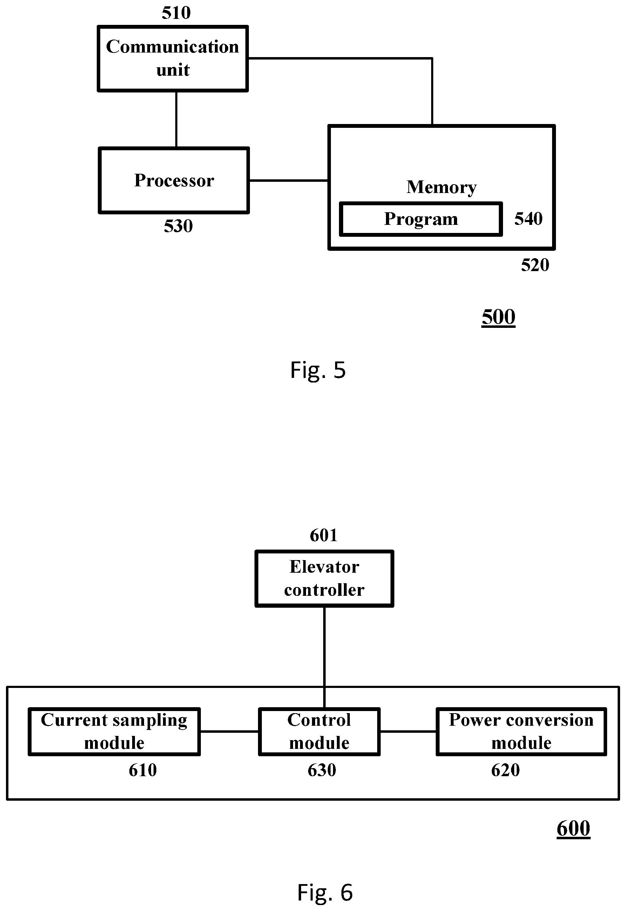

FIG. 5 is a schematic block diagram of a typical computing device.

As shown in FIG. 5, a computing device 500 contains a communication unit 510, a memory 520 (for example, non-volatile memory such as flash memory, ROM, hard disk drive, magnetic disk, optical disc), a processor 530 and a computer program 540.

The communication unit 510, as a communication interface, is configured to establish a communication connection between the computing device and external devices (e.g., an elevator controller and a current sampling module) or networks (e.g., the Internet).

The memory 520 stores the computer program 540 executable by the processor 530. In addition, the memory 520 may also store data generated when the processor 530 executes the computer program and data (e.g. the measurement of the stator coil current) received from the external device via the communication unit 510.

The processor 530 is configured to run the computer program 540 stored on the memory 520 and access data on the memory 520 (for example, calling the data received from the external device and storing calculation results such as fast Fourier analysis data in the memory 520).

The computer program 540 may include computer instructions for implementing the fault monitoring method described by means of FIG. 3, so that the corresponding fault monitoring method can be implemented when the computer program 540 is run on the processor 530.

FIG. 6 is a schematic block diagram of a power control device for controlling an elevator motor in accordance with some other embodiments of the present application. Exemplarily, the power control device shown in FIG. 6 is a frequency converter.

The power control device 600 shown in FIG. 6 includes a current sampling module 610, a power conversion module 620 and a control module 630 coupled with the current sampling module and the power conversion module.

The current sampling module 610 is configured to measure the current flowing through the stator coil and output it to the control module 630. The power conversion module 620 is configured to output a required voltage and frequency regulated power supply to the elevator motor based on control instructions from the control module 630. The control module 630 is configured to generate corresponding control commands based on control commands from an external control device, such as an elevator controller 601. In addition, the control module 630 is configured to implement a motor fault monitoring function.

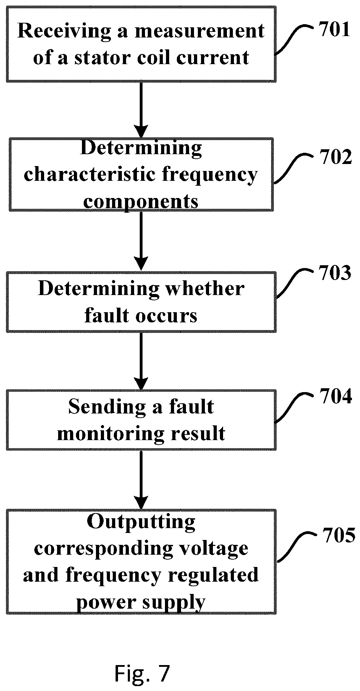

An exemplary motor fault monitoring process performed by the control module 630 is described below with reference to FIG. 7.

The motor fault monitoring process shown in FIG. 7 includes the following steps:
Step 701: receiving the measurement of the stator coil current of the elevator motor from the current sampling module 610.
Step 702: determining one or more characteristic frequency components of the stator coil current from the measurement of the stator coil current. As described above, the characteristic frequency may be 2n times the electrical frequency of the motor (n is a natural number), and the q-axis current of the elevator motor may be selected as the stator coil current. In addition, the characteristic frequency components of the stator coil current may also be determined by the method shown in FIG. 4.
Step 703: determining, based on the characteristic frequency components determined in step 702, whether the elevator motor has a fault of a turn-to-turn short circuit in a stator coil. Optionally, the determination of the fault may be achieved in a manner similar to the embodiment shown in FIG. 3 and will not be repeated here.
Step 704: sending a fault monitoring result to the elevator controller 601. For example, when it is determined that the fault of the turn-to-turn short circuit has occurred at step 703, a message that the turn-to-turn short circuit has occurred in the stator coil will be sent to the elevator controller 601 to cause the elevator controller 601 to generate a corresponding control command based on the message that the turn-to-turn short circuit has occurred in the stator coil, such as generating a control command to stop an elevator car to a specified floor station.

The communication between the control module 630 and the elevator controller 601 may be based on wireless communication and wired communication. Optionally, the wireless communication may be based on various communication protocols, including, for example, but not limited to, Wi-Fi communication protocol, Bluetooth communication protocol and Zigbee communication protocol, etc.

Step 705: generating a corresponding control command and outputting the control command to the power conversion module 620 in response to the control command received from the elevator controller 601, so that the power conversion module 620 provides a corresponding voltage and frequency regulated power supply to the elevator motor based on the control command.

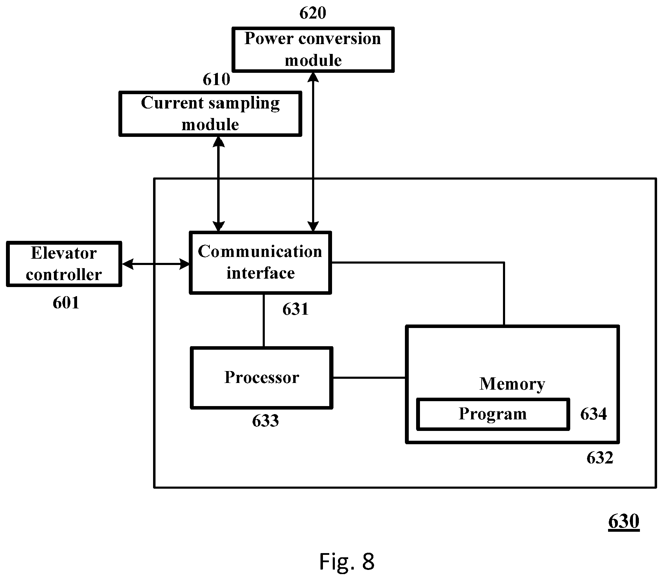

FIG. 8 is a schematic block diagram of a control module included in the power control device of FIG. 6.

As shown in FIG. 8, the control module 630 contains a communication interface 631, a memory 632 (for example, non-volatile memory such as flash memory, ROM, hard disk drive, magnetic disk, optical disc), a processor 633 and a computer program 634.

The communication interface 631, as a communication interface, is configured to establish a communication connection between the control module and external devices (e.g., an elevator controller, a current sampling module and a power conversion module, etc.) or networks (e.g., the Internet).

The memory 632 stores the computer program 634 executable by the processor 633. In addition, the memory 632 may also store data generated when the processor 633 executes the computer program and data (e.g. the measurement of the stator coil current output by the current sampling module 610) received from the external device via the communication interface 631.

The processor 633 is configured to run the computer program 634 stored on the memory 632 and access data on the memory 632 (for example, calling the data received from the external device and storing calculation results such as fast Fourier analysis data in the memory 632).

The computer program 634 may include computer instructions for implementing the fault monitoring method described by means of FIG. 7, so that the corresponding fault monitoring method can be implemented when the computer program 634 is run on the processor 633.

In the embodiments described by means of FIGs. 6 and 8, the power control device can be equipped with motor fault monitoring capabilities simply by upgrading the control software running by the control module 630 or the processor 633, which is advantageous in terms of reducing costs and shortening system development time.

According to another aspect of the present application, there is also provided a computer-readable storage medium on which a computer program is stored. When the program is executed by the processor, one or more steps contained in the method described above with the help of FIGs. 3 and 7 may be realized.

The computer-readable storage medium referred to in the application includes various types of computer storage media, and may be any available medium that may be accessed by a general-purpose or special-purpose computer. For example, the computer-readable storage medium may include RAM, ROM, EPROM, E2PROM, registers, hard disks, removable disks, CD-ROM or other optical disk storage, magnetic disk storage or other magnetic storage devices, or any other transitory or non-transitory medium that may be used to carry or store a desired program code unit in the form of instructions or data structures and that may be accessed by a general-purpose or special-purpose computer or a general-purpose or special-purpose processor. The above combination should also be included in the protection scope of the computer-readable storage medium. An exemplary storage medium is coupled to the processor such that the processor can read and write information from and to the storage medium. In the alternative, the storage medium may be integrated into the processor. The processor and the storage medium may reside in the ASIC. The ASIC may reside in the user terminal. In the alternative, the processor and the storage medium may reside as discrete components in the user terminal.

Those skilled in the art will appreciate that the various illustrative logical blocks, modules, circuits, and algorithm steps described herein may be implemented as electronic hardware, computer software, or combinations of both.

To demonstrate this interchangeability between hardware and software, various illustrative components, blocks, modules, circuits, and steps have been described above generally in terms of their functionality. Whether such functionality is implemented in hardware or software depends on the particular application and design constraints imposed on the overall system. Those skilled in the art may implement the described functionality in varying ways for the particular application. However, such implementation decisions should not be interpreted as causing a departure from the scope of the present application.

Although only a few of the specific embodiments of the present application have been described, those skilled in the art will recognize that the present application may be embodied in many other forms without departing from the spirit and scope thereof. Accordingly, the examples and embodiments shown are to be regarded as illustrative and not restrictive, and various modifications and substitutions may be covered by the application without departing from the spirit and scope of the application as defined by the appended claims.

The embodiments and examples presented herein are provided to best illustrate embodiments in accordance with the present technology and its particular application, and to thereby enable those skilled in the art to implement and use the present application. However, those skilled in the art will appreciate that the above description and examples are provided for convenience of illustration and example only. The presented description is not intended to cover every aspect of the application or to limit the application to the precise form disclosed.

## Claims

1. A fault monitoring device for an elevator motor, comprising:
a memory (520);
a processor (530) coupled with the memory (520); and
a computer program (540) stored on the memory (520) and running on the processor (530), the running of the computer program (540) causes the device to:
A. determine one or more components of a stator coil current at one or more characteristic frequencies from a measurement of the stator coil current of the elevator motor; and
B. determine, based on the one or more component, whether a fault of turn-to-turn short circuit occurs in the stator coil.

2. The fault monitoring device of claim 1, wherein the fault monitoring device is a computing device independent of an elevator controller and a power control device used to control the elevator motor.

3. The fault monitoring device of claim 1 or claim 2, wherein the running of the computer program (540) further causes the device to:
C. send a message to an elevator controller that the turn-to-turn short circuit has occurred in the stator coil.

4. The fault monitoring device of claim 3, wherein the elevator controller generates a control command to evacuate passengers after stopping an elevator car to the nearest floor station based on the message that the turn-to-turn short circuit has occurred in the stator coil.

5. The fault monitoring device of any preceding claim, wherein the stator coil current is a q-axis current of the elevator motor.

6. The fault monitoring device of any preceding claim, wherein the characteristic frequencies take values of 2n x MEF, wherein n is a natural number and MEF is a Motor Electrical Frequency of the elevator motor.

7. The fault monitoring device of any preceding claim, wherein the running of the computer program (540) causes operation A to be performed in the following manner:
A1. receiving the measurement of the stator coil current from a current sampling module;
A2. performing a fast Fourier analysis on a q-axis current measurement of the stator coil current to generate a current frequency spectrum;
A3. obtaining the components of the stator coil current at the one or more characteristic frequencies from the current frequency spectrum.

8. The fault monitoring device of any preceding claim, wherein the running of the computer program (540) causes operation B to be performed in the following manner:
if it is determined that the one or more components of the stator coil current at the one or more characteristic frequencies are greater than respective thresholds, the fault of turn-to-turn short circuit in the stator coil is determined to have occurred;
optionally wherein the running of the computer program (540) further causes operation B to be performed in the following manner:
determining a level of the fault of turn-to-turn short circuit in the stator coil based on a degree of upward deviation of the components of the stator coil current at the one or more characteristic frequencies relative to the respective thresholds; and/or
optionally wherein the respective thresholds are set based on the number of turns of the stator coil of the elevator motor, and the respective thresholds decrease as the number of turns increases.

9. A power control device (600) for controlling an elevator motor, comprising:
a current sampling module (610);
a power conversion module (620);
a control module (630) coupled with the current sampling module (610) and the power conversion module (620), configured to perform the following operations:
A. determining one or more components of a stator coil current at one or more characteristic frequencies from the stator coil current of the elevator motor measured by the current sampling module; and
B. determining, based on the one or more components, whether a fault of turn-to-turn short circuit occurs in the stator coil.

10. The power control device (600) of claim 9, wherein the power control device (600) is a frequency converter.

11. The power control device (600) of claim 9 or claim 10, wherein the control module (630) is further configured to:
C. send a message to an elevator controller that the turn-to-turn short circuit has occurred in the stator coil; and
D. provide a required voltage and frequency regulated power supply to the elevator motor by controlling the power conversion module (620) based on a control command received from the elevator controller, wherein the control command is generated based on the message that the turn-to-turn short circuit has occurred in the stator coil,
optionally, wherein the control command is a control command to stop an elevator car to a specified floor station.

12. The power control device (600) of any one of claims 9-11, wherein the control module (630) is configured to determine the components of the stator coil current at one or more characteristic frequencies by:
A1. performing a fast Fourier analysis on a measurement of the stator coil current to generate a current frequency spectrum;
A2. obtaining the components of the stator coil current at the one or more characteristic frequencies from the current frequency spectrum;
wherein optionally the characteristic frequencies take values of 2n x MEF, wherein n is a natural number and MEF is a Motor Electrical Frequency of the elevator motor.

13. A fault monitoring method for an elevator motor, comprising:
A. determining one or more components of a stator coil current at one or more characteristic frequencies from a measurement of the stator coil current of the elevator motor; and
B. determining, based on the one or more components, whether a fault of turn-to-turn short circuit occurs in the stator coil.

14. The fault monitoring method of claim 13, wherein the method further comprises:
C. sending a message to an elevator controller that the turn-to-turn short circuit has occurred in the stator coil;
optionally wherein the message that the turn-to-turn short circuit has occurred in the stator coil causes the elevator controller to generate a control command to stop an elevator car to a specified floor station.

15. A computer-readable storage medium having instructions stored in the computer-readable storage medium, which is **characterized in that**, when the instructions are executed by a processor, the processor is caused to execute the method of claim 13 or claim 14.
